# EUROPEAN PATENT SPECIFICATION

(11) **EP 0 615 257 B1**
(45) Date of publication and mention of the grant of the patent: **02.06.1999**
(21) Application number: 94200542.2
(22) Date of filing: 03.03.1994
(51) Int. Cl.: H01B 1/12, C08G 61/12, H05K 9/00

(54) **Method of manufactoring a laminated structure of a metal layer on a conductive polymer layer**
Methode zur Herstellung eines Verbundstoffes mit einer Metallschicht auf einer leitfähigen Polymerschicht
Méthode de fabrication d'une structure laminée ayant une couche métallique sur une couche de polymère conducteur

(30) Priority: 09.03.1993 EP 93200665; 07.09.1993 EP 93202602
(43) Date of publication of application: 14.09.1994
(73) Proprietor: Koninklijke Philips Electronics N.V., 5621 BA Eindhoven (NL)
(72) Inventor: De Leeuw, Dagobertt Michel, NL-5656 AA Eindhoven (NL); Mutsaers, Cornelius Marcus Johannes, NL-5656 AA Eindhoven (NL); Simenon, Maurice Maria Johannes, NL-5656 AA Eindhoven (NL)
(74) Representative: Stolk, Steven Adolph

(56) References cited:
- EP-A- 0 288 807
- EP-A- 0 364 368
- EP-A- 0 399 299
- EP-A- 0 478 368
- EP-A- 0 615 256

## Description

The invention relates to a method of manufacturing a laminated structure.

Structures obtained using such a method are used as printed circuit boards, in which a metal layer (mostly copper) is provided in accordance with the desired conductive track pattern. A substrate material is used which is made of, for example, synthetic resin, a composite material such as glass fibre/epoxy, paper/phenolic resin or ceramic. The substrate material is generally flat and plate-shaped, although it may alternatively be formed by a flat or curved form of, for example, the synthetic resin housing of a domestic appliance or shaver.

A printed circuit board can be manufactured by providing a substrate with a copper foil via an adhesive layer. The copper foil is provided with a photoresist layer and, in succession, exposed to patterned radiation and developed, whereafter the undesired copper is removed in a chemical etching bath. For reasons relating to the protection of the environment, this method is less desirable. In accordance with another method, the substrate, which is non-conductive, is provided with a copper layer in an electroless process. To this end, the substrate is first activated with a noble metal, such as palladium, and then immersed in an electroless metallization bath. Such a bath contains an aqueous solution of, *inter alia,* a copper salt, a complexing agent such as EDTA, and a reducing agent such as formaldehyde. The copper layer provided in an electroless process is generally reinforced with a copper layer applied by means of electrodeposition. In this process an external current source is used to electrodeposit copper onto the copper layer forming the cathode from an aqueous copper-salt solution.

However, electroless metallization has the drawback that the activation is non-selective, so that the deposited uniform copper layer must subsequently be provided with a pattern in a photolithographic process and by means of chemical etching, which is very laborious. Another drawback is that expensive noble metals (such as palladium) are necessary to activate the substrate surface and that the metallization baths used readily become instable. Moreover, said metallization baths contain toxic components such as the above-mentioned complexing and reducing agents.

A method of the type mentioned in the opening paragraph is known from an article by S. Gottesgeld et al. in J. Electrochem. Soc. Vol. 139, No. 1, L14 (1992). Using the known method, a structure is manufactured by providing a substrate with an electrically conductive polypyrrole layer. To this end the substrate is immersed in an aqueous solution of pyrrole and a ferri-salt. After an immersion time in this solution of at least 0.5 hour an electrically conductive polypyrrole layer having a specific conductivity of 60 S/cm is formed on the substrate. The sheet resistance is a few hundred Ω/square. Although in general polymers are poor conductors, it is known that polymers comprising poly-conjugated chains obtain electrically conductive properties. Said conductivity is referred to as intrinsic conductivity. Examples of such polymers are: polyacetylene, polyaniline, polythiophene and polypyrrole. The conductivity of these polymers is generally low but it can be increased by, for example, (electro)chemically oxidizing, referred to as doping, the polymer, resulting in the formation of p-type conductors. Suitable dopants for obtaining p-type conduction are, for example, I₂, AsF₅, SbF₅, HBF₄, perchlorates, sulphonates, SO₃ and FeCl₃. This doping results in the formation of positive charge carriers on the polymer chains, which charges are compensated for by negatively charged counter-ions. The sheet resistance of the doped polypyrrole layer thus obtained is sufficiently low to provide this layer with a copper layer in an electrodeposition process.

A disadvantage of the known method is that the copper layer is non-selectively provided, so that it is still necessary to structure the uniform copper layer at a later stage to obtain the desired pattern. According to said article, the copper layer can be structured by removing the undesired polypyrrole from the substrate. The article does not indicate how this could be done; in any case, removal of undesired, conductive polypyrrole requires an additional process step.

It is an object of the invention to provide, *inter alia*, a simple method of manufacturing a laminated structure, which does not have the above-mentioned disadvantages, in particular a method in which no electroless metallization baths are used and in which metallization takes place selectively according to the desired pattern.

This object is achieved by a method as claimed in Claim 1. The invention is based on the insight that for growing a metal layer on a conductive polymer layer by electrodeposition, a maximum sheet resistance is required to obtain a minimum difference in layer thickness of the metal layer, and, in addition, for obtaining the desired pattern definition the sheet resistance of the parts of the polymer layer on which the metal layer is undesired must be at least a factor of 10⁶ higher than the sheet resistance of the conductive parts. This means that if the layer thicknesses of the conductive parts and the substantially non-conductive parts of the polymer layer are equal, the ratio of the respective sheet resistances is at least 10⁶. In particular for the manufacture of narrow metal tracks a low sheet resistance of the polymer pattern is important to electrodeposit metal in a uniform layer from a metal-salt solution. Too high an ohmic drop in the conductive polymer pattern during electrolysis causes a smaller metal deposition in areas which are further removed from the electrical connection point of the external current source. Pattern definition is important if metal tracks are located at a small distance (for example 0.5 mm) from each other. A high sheet resistance of areas situated between the satisfactorily conducting areas of the polymer layer precludes metal from being electrodeposited in these areas and hence undesired short-circuits between the metal tracks in subsequent applications.

For the substrate of the method in accordance with the invention use can be made of synthetic resins, glass, quartz, ceramic and composite materials such as glass fibre/epoxy (FR-4), paper/phenolic resin (FR-2) and paper/epoxy resin (FR-3). The substrate may be in the form of a separate part or it may be integral with a housing part, which may or may not be curved, of an electric device.

A suitable embodiment of the method in accordance with the invention is characterized in that the polymer layer comprises predominantly polyaniline (PANI). As explained in greater detail hereinbelow, PANI can be manufactured both in a conductive state and in a substantially non-conductive state. In a typical example, conductive PANI has a specific conductivity of 48 S/cm and a sheet resistance of 100 Ω/square at a layer thickness of 2.1 µm. At the same layer thickness, the substantially non-conductive PANI has a sheet resistance of 10⁹ Ω/square.

Copper is generally used for the metal layer of the track pattern because it has a satisfactory conductivity, solderability and many electroplating copper baths are available. Also other metals can be provided by electroplating, for example silver, nickel, chromium, tin, lead and alloys of said metals.

Another suitable method in accordance with the invention is characterized in that a layer of a solution comprising conductive polyaniline, a photochemical radical generator and a solvent is provided on the substrate, whereafter the layer is exposed to patterned radiation, thereby forming substantially non-conductive polymer in the exposed areas, and then heated, after which the metal layer is electrodeposited onto the conductive polyaniline from a metal-salt solution. It has been found that conductive polyaniline becomes substantially non-conductive if specific radicals are generated in said polyaniline. Said radicals can be obtained photochemically. Aliphatic phenylketones such as l-benzoyl-1-cyclohexanol are very effective photochemical radical generators. The ratio between the sheet resistances of the exposed and the unexposed areas is above 10⁷, so that selective metallization of the unexposed areas is possible. Exposure takes place by irradiation with deep UV-light (wavelength < 320 nm). In the heating step, unreacted radical generators are removed by evaporation.

The above-described method in accordance with the invention forms a negative process: the exposed areas of the polymer layer become non-conductive.

The method in accordance with the invention enables a metal layer to be selectively electrodeposited onto a substate in a simple manner, without using an electroless metallization bath and without photolithographic etching treatment.

The invention will be explained in greater detail by means of an exemplary embodiment.

### Exemplary embodiment

Conductive polyaniline is prepared by adding an aqueous solution of (NH₄)₂S₂O₈ to a hydrochloric acid solution of aniline. The precipitated polyaniline is filtered-off and washed with water. This synthesis is described in an article by Y. Cao et al. in Polymer, 30, 2305-2311 (1989). A quantity of 2 g of a solution is prepared which consists of 0.5 wt. % of conductive polyaniline in m-cresol. A quantity of 0.15 g of 1-benzoyl-1-cyclohexanol is added to this solution. The solution is spin coated onto a glass substrate. The polymer layer obtained is dried at 90° C for 1 minute. The thickness of the polymer layer is 2.1 µm. Subsequently the dried polymer layer is exposed to patterned radiation with deep UV-light in a nitrogen atmosphere. The unexposed parts of the polymer layer have a sheet resistance of 100 Ω/square (calculated specific conductivity 48 S/cm), whereas the exposed parts have a value in excess of 10⁹ Ω/square. Subsequently, copper from the electroplating bath of exemplary embodiment 1 is deposited on the unexposed areas of the polymer layer. In this manner, copper tracks having a width of 0.5 mm are produced.

The same result is obtained if polycresol formaldehyde (Bakelite™) is used as the substrate material.

The method in accordance with the invention enables polymer patterns to be photochemically produced in a polymer layer, the sheet resistance of the conductive parts of the polymer pattern being maximally 1000 Ω/square and, in addition, a factor of at least 10⁶ lower than the sheet resistance of the unexposed parts. In accordance with the invention, the conductive polymer pattern can be selectively provided with a metal layer by electrodeposition, thereby forming a corresponding metal pattern. Thus, the method in accordance with the invention can very suitably be used for the additive manufacture of metal patterns and, hence, is a favourable alternative to electroless metallization.

## Claims

1. A method of manufacturing a laminated structure comprising the steps of:
a) providing an electrically insulating substrate;
b) applying a solution of an electrically conducting polymer and a photochemical radical generator on the electrically insulating substrate to form a layer of said polymer with a sheet resistance of maximally 1000 Ω/square;
c) irradiating the polymer layer, thereby forming a pattern of areas of substantially non-conductive polymer whose sheet resistance is at least a factor of 10⁶ higher than that of the conductive polymer, while leaving areas of the polymer layer which are not irradiated electrically conductive;
d) electrodepositing a metal layer on the electrically conductive areas of the polymer layer.

2. A method as claimed in Claim 1, characterized in that the polymer layer comprises predominantly polyaniline.

3. A method as claimed in Claim 1, characterized in that the metal layer comprises predominantly copper.

4. A method of manufacturing a laminated structure as claimed in Claim 2, characterized in that a layer of a solution comprising conductive polyaniline, a photochemical radical generator and a solvent is provided on the substrate, whereafter the layer is exposed to patterned radiation, thereby forming substantially non-conductive polymer in the exposed areas, and then heated, after which the metal layer is electrodeposited onto the conductive polyaniline from a metal-salt solution.

5. A method as claimed in Claim 4, characterized in that aliphatic phenylketone is used as the photochemical radical generator.

## Patentansprüche

1. Verfahren zum Herstellen eines Verbundstoffes, wobei dieses Verfahren die nachfolgenden Verfahrensschritte aufweist:
a) das Schaffen einer elektrisch isolierenden Trägers;
b) das Anbringen einer Lösung aus einem elektrisch leitenden Polymers und eines photochemischen Radikalformers auf dem elektrisch isolierenden Träger zum Bilden einer Schicht aus dem genannten Polymer mit einem Quadratwiderstand von maximal 1000 Ohm/Quadrat;
c) das Bestrahlen der Polymerschicht, wodurch ein Muster von Gebieten aus im wesentlichen nicht-leitendem Polymer gebildet wird, deren Quadratwiderstand um wenigstens einen Faktor 10⁶ höher ist als der des leitenden polymers, während Gebiete der Polymerschicht, die nicht bestrahlt wurden, elektrisch leitend gelassen werden;
d) galvanische Abscheidung einer Metallschicht auf den elektrisch leitenden Genieten der Polymerschicht.

2. Verfahren nach Anspruch 1, dadurch gekennzeichnet, dass die Polymerschicht hauptsächlich Polyanilin enthält.

3. Verfahren nach Anspruch 1, dadurch gekennzeichnet, dass die Metallschicht hauptsächlich Kupfer enthält.

4. Verfahren zum Herstellen von Verbundstoffen nach Anspruch 2, dadurch gekennzeichnet, dass auf dem Träger eine Schicht einer Lösung angebracht wird, die leitendes Polyanilin, einen photochemischen Radikalformer und ein Lösungsmittel enthält, auf dem Träger angebracht wird, wonach die Schicht einer mustermäßigen Bestrahlung ausgesetzt wird, wodurch in den belichteten Gebieten im Wesentlichen nicht-leitendes Polymer gebildet und das Ganze erhitzt wird, wonach die Metallschicht aus einer Metallsalzlösung auf dem leitenden Polyanilin galvanisch abgeschieden wird.

5. Verfahren nach Anspruch 4, dadurch gekennzeichnet, dass als photochemischer Radikalformer aliphatisches Phenylketon verwendet wird.

## Revendications

1. Procédé pour fabriquer une structure laminée comportant les étapes suivantes :
a) l'application d'un substrat électriquement isolant ;
b) l'application d'une solution constituée d'un polymère électriquement conducteur et d'un générateur de radical photochimique sur le substrat électriquement conducteur de manière à constituer une couche dudit polymère présentant une résistance par carré égale à tout au plus 1000 Ω/carré ;
c) l'irradiation de la couche polymère, de ce fait constituant une configuration de zones de polymère sensiblement non conducteur dont la résistance par carré est supérieure d'un facteur au moins égal à 10⁶ à celle du polymère conducteur, alors que l'on maintient électriquement conductrices des zones de la couche polymère qui ne sont pas irradiées ;
d) l'électrodéposition d'une couche métallique sur les zones électriquement conductrices de la couche polymère.

2. Procédé selon la revendication 1, caractérisé en ce que la couche polymère comporte d'une manière prédominante de la polyaniline.

3. Procédé selon la revendication 1, caractérisé en ce que la couche métallique comporte d'une manière prédominante du cuivre.

4. Procédé pour fabriquer une structure laminée selon la revendication 2, caractérisé en ce qu'une couche constituée d'une solution comportant de la polyaniline conductrice, un générateur de radical photochimique et un solvant est déposée sur le substrat, après quoi la couche est exposée au rayonnement mis en configuration, de ce fait constituant du polymère sensiblement non conducteur dans les zones exposées, et alors chauffée, après quoi la couche métallique est déposée par électrolyse, à partir d'une solution constituée de métal et de sel, sur la polyaniline conductrice.

5. Procédé selon la revendication 4, caractérisé en ce que l'on utilise de la phénylcétone aliphatique comme générateur de radical photochimique.
